# EUROPÄISCHE PATENTANMELDUNG

(11) **EP 4 640 498 A1**
(43) Veröffentlichungstag der Anmeldung: **29.10.2025**
(21) Anmeldenummer: 25159099.8
(22) Anmeldetag: 20.02.2025
(51) Int. Cl.: B60R 21/23

(54) **KAMERA-MONITOR-SYSTEM SOWIE FAHRZEUG MIT KAMERA-MONITOR-SYSTEM**

(30) Priorität: 22.04.2024 DE 102024111198
(71) Anmelder: MEKRA LANG GmbH & Co. KG, 91465 Ergersheim (DE)
(72) Erfinder: Traub, Christian, 91522 Ansbach (DE); Schuh, Martin, 91617 Oberdachstetten (DE)
(74) Vertreter: Winter, Brandl - Partnerschaft mbB

(57) **Zusammenfassung**

Die Erfindung betrifft ein Kamera-Monitor-System (1) für ein Fahrzeug (2), vorzugsweise ein Nutzfahrzeug, mit einer Kamera (3), einem Monitor (4), einer Monitorhalterung (5) und einer Platine (7), wobei der Monitor (4) mechanisch in der Monitorhalterung (5) verbaut ist und wobei die Monitorhalterung (5) eine Fahrzeugschnittstelle (6) zur mechanischen Anbindung an das Fahrzeug (2) aufweist, wobei die Platine (7) mechanisch in der Monitorhalterung (5) verbaut ist. Zudem betrifft die Erfindung ein Fahrzeug (2) mit einem solchen Kamera-Monitor-System (1).

## Beschreibung

Die Erfindung betrifft ein Kamera-Monitor-System für ein Fahrzeug, vorzugsweise ein Nutzfahrzeug oder einen Personenkraftwagen. Zudem betrifft die Erfindung ein Fahrzeug, insbesondere Nutzfahrzeug oder Personenkraftwagen, mit einer Fahrzeugkabine, einer Daten- und/oder Kommunikationseinheit und dem Kamera-Monitor-System.

Aus dem Stand der Technik sind bereits Kamera-Monitor-Systeme für Fahrzeuge bekannt. Insbesondere finden diese im Nutzfahrzeugbereich Anwendung. Solche Kamera-Monitor-Systeme finden jedoch auch zunehmend Anwendung im Personenkraftwagenbereich.

Solche Kamera-Monitor-Systeme weisen eine insbesondere außen am Fahrzeug angebrachte oder anbringbare Kamera sowie einen insbesondere innen im Fahrzeug angebrachten oder anbringbaren Monitor auf. Auf dem Monitor kann ein durch die Kamera erfasster Bildbereich für einen Fahrer des Fahrzeugs angezeigt werden.

Zudem weisen die Kamera-Monitor-Systeme eine Monitorhalterung zur Anbringung des Monitors am bzw. im Fahrzeug auf. Dazu weist die Monitorhalterung eine Fahrzeugschnittstelle zur mechanischen Anbindung an das Fahrzeug auf und der Monitor ist mechanisch in der Monitorhalterung (und für einen Benutzer bzw. den Fahrer vorzugsweise nicht lösbar) verbaut.

Zwischen dem Fahrzeug und dem Kamera-Monitor-System, zwischen einzelnen Bestandteilen des Kamera-Monitor-Systems untereinander und/oder zwischen dem Fahrzeug und den einzelnen Bestandteilen des Kamera-Monitor-Systems können unterschiedliche Daten übertragen werden. Zur Verarbeitung und/oder zum Empfangen und/oder zum Senden dieser Daten weist das Kamera-Monitor-System eine Platine (oder mehrere Platinen) auf.

Bei bekannten Kamera-Monitor-Systemen wird die Platine räumlich oftmals in einen Kameraflügel bzw. ein Kameragehäuse und/oder im Monitor integriert, was jedoch zu größeren Abmessungen und/oder einem höheren Gewicht bzw. einer ungünstigen Gewichtsverteilung des Kameraflügels und/oder des Monitors führt und insbesondere aufgrund der außenseitigen Positionierung des Kameraflügels Nachteile hinsichtlich Aerodynamik und Aussetzung von Umwelteinflüssen mit sich bringt.

Alternativ kann die Platine räumlich als separate Einzelkomponente angeordnet werden, was jedoch zu einem höheren Montageaufwand führt und zusätzlichen Bauraum im Fahrzeug in Anspruch nimmt.

Es ist daher die Aufgabe der Erfindung, die Nachteile aus dem Stand der Technik zu vermeiden oder wenigstens zu verringern. Insbesondere soll ein Kamera-Monitor-System für ein Fahrzeug sowie ein Fahrzeug mit einem solchen Kamera-Monitor-System bereitgestellt werden, bei denen die Platine besonders vorteilhaft hinsichtlich Funktionalität, Fertigungsaufwand und Montierbarkeit positioniert werden kann.

Die Aufgabe der Erfindung wird durch ein Kamera-Monitor-System mit den Merkmalen des Anspruchs 1 sowie durch ein Fahrzeug mit den Merkmalen des nebengeordneten Patentanspruchs gelöst. Vorteilhafte Weiterbildungen sind Gegenstand der Unteransprüche.

Demnach betrifft die vorliegende Erfindung ein Kamera-Monitor-System für ein Fahrzeug, vorzugsweise ein Nutzfahrzeug, mit einer Kamera, einem Monitor, (zumindest) einer Platine und einer Monitorhalterung. Dabei ist der Monitor mechanisch in der Monitorhalterung verbaut und die Monitorhalterung weist eine Fahrzeugschnittstelle zur mechanischen Anbindung an das Fahrzeug auf. Erfindungsgemäß ist die Platine mechanisch in der Monitorhalterung verbaut. Durch die Anordnung in der Monitorhalterung kann vermieden werden, dass der Kameraflügel für die Aufnahme der Platine vergrößert werden muss. Gleichzeitig kann eine einfache Verbindung zu dem Monitor und/oder der Kamera und/oder dem Fahrzeug hergestellt werden.

Gemäß einer bevorzugten Ausführungsform kann die Platine (oder eine der mehreren Platinen) elektronisch mit der Kamera verbunden sein. Das heißt, dass die Platine eine elektronische Verbindung zur Kamera aufweist. Dadurch können Daten von der Platine zur Kamera und/oder von der Kamera zur Platine übertragen werden.

Gemäß einer bevorzugten Ausführungsform kann die Platine (oder eine der mehreren Platinen) elektronisch mit dem Monitor verbunden sein. Das heißt, dass die Platine eine elektronische Verbindung zum Monitor aufweist. Dadurch können Daten von der Platine zum Monitor und/oder von dem Monitor zur Platine übertragen werden.

Gemäß einer bevorzugten Ausführungsform kann die Platine (oder eine der mehreren Platinen) elektronisch mit dem Fahrzeug verbunden oder verbindbar sein. Das heißt, dass die Platine eine elektronische Verbindung zum Fahrzeug aufweist. Dadurch können Daten von der Platine zum Fahrzeug und/oder von dem Fahrzeug zur Platine übertragen werden.

Gemäß einer bevorzugten Ausführungsform kann die Platine mechanisch, beispielsweise über eine Schraubverbindung, Klemmverbindung, Schnappverbindung und/oder Stoffschlussverbindung, direkt mit der Monitorhalterung verbunden sein. So kann eine geeignete mechanische Verbindung realisiert werden.

Gemäß einer alternativen bevorzugten Ausführungsform kann das Kamera-Monitor-System ein die Platine umgebendes Platinengehäuse aufweisen. Gemäß der alternativen bevorzugten Ausführungsform kann das Platinengehäuse separat von der Monitorhalterung ausgebildet sein und mechanisch, beispielsweise über eine Schraubverbindung, Klemmverbindung und/oder Schnappverbindung, mit der Monitorhalterung verbunden sein. So kann eine geeignete mechanische Verbindung realisiert werden.

Gemäß einer Weiterbildung der bevorzugten Ausführungsform kann die Platine und/oder das Platinengehäuse eine Steck- und/oder Kabelverbindung zur elektrischen Verbindung mit der Kamera und/oder dem Monitor und/oder dem Fahrzeug aufweisen.

Gemäß der Weiterbildung der bevorzugten Ausführungsform kann eine an der Platine oder dem Platinengehäuse ausgebildete Steckverbindung im montierten Zustand des Kamera-Monitor-Systems nach unten ausgerichtet sein. So wird zusätzlich verhindert, dass in das Kamera-Monitor-System eingedrungenes Wasser an der Steckverbindung mit der Platine in Kontakt kommen kann.

Gemäß einer bevorzugten Ausführungsform kann der Monitor eine Anzeigeeinheit und ein Monitorgehäuse bzw. eine Monitorabdeckung aufweisen. Die Anzeigeeinheit kann insbesondere einen Bildschirm bzw. ein Anzeigepanel aufweisen. Zudem kann die Anzeigeeinheit eine Monitorplatine, beispielsweise zum Empfangen eines verarbeiteten Bildes, zum Aufbereiten einer Anzeige auf dem Bildschirm und/oder zur Realisierung von sicherheitsrelevanten Mechanismen, aufweisen. Beispielsweise kann die Monitorplatine dabei ausgelagert im Monitorhalter verbaut sein.

Gemäß einer Weiterbildung der bevorzugten Ausführungsform kann das Monitorgehäuse separat von der Monitorhalterung ausgebildet sein und mechanisch, beispielsweise über eine Schraubverbindung, Hakenverbindung und/oder Bolzenverbindung, mit der Monitorhalterung verbunden sein. Die Verbindung zwischen dem Monitorgehäuse und der Monitorhalterung kann insbesondere für einen Endkunden/Benutzer/Fahrer nicht lösbar ausgebildet sein. Das heißt, dass die Verbindung zwischen dem Monitorgehäuse und der Monitorhalterung beispielsweise nur vom Hersteller zum Austausch einzelner Komponenten des Kamera-Monitor-Systems lösbar ist.

Gemäß einer alternativen Weiterbildung der bevorzugten Ausführungsform kann das Monitorgehäuse integral durch die Monitorhalterung gebildet sein. Das heißt, dass eine hintere Abdeckung des Monitors durch die Monitorhalterung mit ausgebildet ist. Insbesondere handelt es sich bei der in der Monitorhalterung verbauten Platine in diesem Fall nicht ausschließlich um die Monitorplatine, sondern vorzugsweise um eine Platine mit anderen oder zusätzlichen Funktionen.

Gemäß einer bevorzugten Ausführungsform kann die Fahrzeugschnittstelle ausgebildet sein, um an einer A-Säule einer Fahrzeugkabine des Fahrzeugs so montiert zu werden, dass der Monitor (im an dem Fahrzeug montierten Zustand des Kamera-Monitor-Systems) an einer Vorderseite der Monitorhalterung positioniert ist und die A-Säule (im an dem Fahrzeug montierten Zustand des Kamera-Monitor-Systems) an einer Rückseite oder an einer Seite der Monitorhalterung positioniert ist. So hat ein Fahrer eine freie Sicht auf den Monitor.

Gemäß einer Ausführungsform kann die Monitorhalterung einen Innenraum ausbilden. Das heißt, dass die Monitorhalterung einen Hohlraum zur Aufnahme von Komponenten des Kamera-Monitor-Systems ausbildet. Dabei ist die Platine bzw. das Platinengehäuse mit der Platine vorzugsweise in dem Innenraum angeordnet.

Gemäß einer bevorzugten Ausführungsform kann die Monitorhalterung eine in dem Innenraum angeordnete Kabelführung aufweisen. Die Kabelführung kann insbesondere zur Fixierung von einem zu dem Monitor führenden Kabel (d.h. ein mit dem Monitor verbundenes Kabel) und/oder von einem zu der Platine führenden Kabel (d.h. ein mit der Platine verbundenes Kabel) und/oder von zu der Kamera führenden Kabel (d.h. ein mit der Kamera verbundenes Kabel) und/oder von einem zu dem Fahrzeug führenden Kabel (d.h. ein mit dem Fahrzeug verbundenes Kabel) dienen. Dies hat den Vorteil, dass die Positionierung der Kabel fest vorgegeben werden kann und eine sinnvolle Kabelführung gewährleistet werden kann.

Gemäß einer bevorzugten Ausführungsform kann die Monitorhalterung, insbesondere auf ihrer Außenseite und/oder in ihrem Innenraum, einen Wasserablauf aufweisen. Der Wasserablauf kann vorzugsweise so ausgebildet sein, dass Wasser gezielt von der Platine weggeführt wird. Dadurch wird verhindert, dass die Platine mit Wasser in Kontakt kommt und dadurch ggf. Schaden nimmt.

Gemäß einer bevorzugten Ausführungsform kann das Kamera-Monitor-System ein Schirmblech zur Abschirmung der Platine von EMV-Störstrahlung (Elektromagnetische-Verträglichkeit-Störstrahlung) aufweisen. So können unerwünschte gegenseitige Einflüsse vermieden werden.

Gemäß einer Weiterbildung der bevorzugten Ausführungsform kann das Schirmblech vorzugsweise die Platine zumindest teilweise oder auf einer Seite oder vollständig umgebend angeordnet sein. Dies hat den Vorteil, dass eine effektive Abschirmung erzielt wird.

Gemäß einer bevorzugten Ausführungsform kann das Kamera-Monitor-System einen, insbesondere in dem Innenraum der Monitorhalterung angeordneten, Kühlkörper zur Kühlung des Monitors und/oder der Platine aufweisen. So können die Platine und/oder der Monitor vor Überhitzung geschützt werden und folglich die Leistung und/oder die Lebensdauer verbessert werden.

Gemäß einer Weiterbildung der bevorzugten Ausführungsform kann der Kühlkörper auf einer dem Schirmblech gegenüberliegenden Seite der Platine angeordnet sein. So kann eine geeignete Gewichtsverteilung bei effizienter Schirmung und Kühlung erzielt werden.

Gemäß einer Weiterbildung der bevorzugten Ausführungsform kann der Kühlkörper mechanisch, beispielsweise über eine Schraubverbindung, durch Heißverstemmen, durch Verpressen und/oder durch Umspritzen, vorzugsweise mit dazwischen angeordneter Dichtung, an der Monitorhalterung angebracht sein. So kann eine zuverlässige und gleichzeitig einfach herstellbare Anbringung gewährleistet werden.

Gemäß einer Weiterbildung der bevorzugten Ausführungsform kann zwischen dem Kühlkörper und der Platine ein wärmeleitfähiges Element, beispielsweise ein Wärmeleitpad oder eine Wärmeleitpaste, angeordnet sein. So wird eine effiziente Wärmeübertragung gewährleistet. Vorzugsweise kann das wärmeleitfähige Element zwischen dem Kühlkörper und der Platine eingeklemmt sein und/oder mit dem Kühlkörper verklebt sein und/oder mit der Platine verklebt sein. So kann ein unbeabsichtigtes Lösen verhindert werden.

Gemäß einer Weiterbildung der bevorzugten Ausführungsform kann der Kühlkörper im verbauten Zustand nicht von außen (d.h. außerhalb des Kamera-Monitor-Systems, insbesondere der Monitorhalterung) sichtbar sein. Insbesondere kann der Kühlkörper in dem Innenraum der Monitorhalterung angeordnet sein. Durch eine solche Positionierung kann ein Schwerpunkt der Monitorhalterung vorteilhafterweise in Richtung der mechanischen Fahrzeugschnittstelle verlagert werden und/oder ein ansprechendes äußeres Erscheinungsbild gewährleistet werden.

Gemäß einer bevorzugten Ausführungsform kann das Kamera-Monitor-System ein Spiegelersatzsystem sein. Insbesondere kann das Kamera-Monitor-System ein gesetzlich zugelassenes Spiegelersatzsystem sein. Beispielsweise kann das Kamera-Monitor-System, ein nach UN/ECE-R46 zugelassenes Spiegelersatzsystem sein. Insbesondere für eine solche Anwendung ist die Positionierung der Platinen von hoher Bedeutung.

Gemäß einer bevorzugten Ausführungsform kann zumindest eine Außenwand der Monitorhalterung (vorzugsweise vollständig) aus Kunststoff ausgebildet sein. Das heißt, dass alle sichtbaren Teile der Monitorhalterung aus Kunststoff ausgebildet sind. So kann eine robuste Monitorhalterung bereitgestellt werden, die gleichzeitig einfach herstellbar ist.

Gemäß einer bevorzugten Ausführungsform kann die Platine bzw. eine der mehreren Platinen eine Verarbeitungseinheit der Kamera, d.h. eine Kameraplatine, sein. Die Kameraplatine kann beispielsweise zur Rohdatenverarbeitung dienen.

Gemäß einer bevorzugten Ausführungsform kann die Platine bzw. eine der mehreren Platinen eine Verarbeitungseinheit des Monitors, d.h. eine Monitorplatine, sein. Die Monitorplatine kann beispielsweise zum Empfangen eines verarbeiteten Bildes und/oder zum Aufbereiten einer Anzeige auf dem Bildschirm und/oder zur Realisierung von sicherheitsrelevanten Mechanismen dienen.

Gemäß einer bevorzugten Ausführungsform kann die Platine bzw. eine der mehreren Platinen eine weitere Verarbeitungseinheit des Kamera-Monitor-Systems, d.h. eine Kamera-Monitor-System-Platine, sein. Die Kamera-Monitor-System-Platine kann beispielsweise zur Bilderkennung dienen. Alternativ oder zusätzlich kann die weitere Verarbeitungseinheit eine elektronische Fahrzeugschnittstelle abbilden.

Die Erfindung betrifft auch ein Fahrzeug, insbesondere Nutzfahrzeug, mit einer Fahrzeugkabine, insbesondere einer A-Säule, einer Daten- und/oder Kommunikationseinheit, und einem beschriebenen Kamera-Monitor-System. Dabei ist die Fahrzeugschnittstelle der Monitorhalterung mit der Fahrzeugkabine, insbesondere der A-Säule, beispielsweise über eine oder zwei Schrauben, mechanisch verbunden oder verbindbar. Alternativ oder zusätzlich ist die Platine mit der Daten- und/oder Kommunikationseinheit, wie beispielsweise einem Fahrzeugnetzwerk, des Fahrzeugs elektronisch verbunden oder verbindbar.

Mit anderen Worten betrifft die Erfindung eine Platine (ECU, electronic control unit) im Monitorhalter (d.h. in der Monitorhalterung). Hintergrund ist, dass der Verbauraum in Fahrzeugen stark begrenzt ist. Bisher können Platinen als zusätzliche "Boxen" vorliegen. Alternativ können die Platinen als zentrale Recheneinheiten als separate "Box" mit Gehäuse vorliegen. Die Recheneinheiten/ Verarbeitungseinheiten werden in aktuellen Systemen in den Kameraflügel oder den Monitor integriert, wobei die Integration in den Kameraflügel zu einer größeren Bauform und höherem Gewicht des Kameraflügels führt, und daher aerodynamisch gegenüber abgesetzten Sensorköpfen, d.h. einem Sensorkopf mit räumlich getrennter Verarbeitungseinheit, benachteiligt ist. Zudem ist der Verbau der Platine an der Außenseite des Fahrzeugs aufgrund der herrschenden Umwelteinflüsse nicht vorteilhaft. Weiter führen zusätzliche Einzelkomponenten des Systems beim Kunden zu höheren Montageaufwänden. Dagegen bieten integrierte Systeme keine Möglichkeit einfach Einzelkomponenten auszutauschen, beispielsweise bei Lieferengpässen oder Reklamationsfällen. Daher liegt der Erfindung das Problem zugrunde, dass eine Lösung für zusätzliche Platinen gefunden wird, die weder im Monitor direkt noch in der Kamera verbaut sind, keinen zusätzlichen Montageaufwand beim Kunden erzeugen und keinen zusätzlichen Bauraum benötigen. Insbesondere betrifft die Erfindung daher einen Monitorhalter für ein Kamera-Monitor-System zum Einsatz in einem Fahrzeug, insbesondere in einem Nutzfahrzeug, umfassend eine mechanische, insbesondere eine tragende Funktion habende, beispielsweise in Form von Schrauben, Anbindung des Monitorhalters an das Fahrzeug; eine mechanische Anbindung eines Monitors des Kamera-Monitor-Systems an den Monitorhalter; wobei mindestens eine elektronische Platine des Kamera-Monitor-Systems, mit wenigstens einer elektronischen Verbindung zum Monitor und/oder der Kamera des Kamera-Monitor-Systems und/oder zum Fahrzeug, insbesondere zur Spannungsversorgung, Verbindung zum Fahrzeugnetzwerk mechanisch in dem Monitorhalter verbaut ist. Durch den Verbau von elektronischen Platinen des Kamera-Monitor-Systems in den Monitorhalter, können die Bauformen des Kameraflügels und des Monitors deutlich reduziert werden und zusätzlich ergibt sich kein benötigter, weiterer Verbauraum für das System. Der Montageaufwand bei Kunden wird dadurch nicht zusätzlich erhöht. Das Gewicht des Monitors wird gegebenenfalls reduziert und der Schwerpunkt des Gewichts wandert weiter zur A-Säule, wodurch der Monitor für eine geringere Belastung ausgelegt sein muss, verglichen mit einem (direkten) Verbau der Platinen im Monitor. Hierdurch werden gegebenenfalls auch Schwingungen reduziert.

Die Erfindung wird nachfolgend mit Hilfe von Figuren erläutert. Es zeigen:
Fign. 1 bis 3 eine prinzipielle Positionierung eines Kamera-Monitor-Systems und einen grundsätzlichen Aufbau des Kamera-Monitor-Systems,
Fign. 4 und 5 perspektivische Darstellungen unterschiedlicher Ausführungsformen einer Monitorhalterung und eines Monitors des Kamera-Monitor-Systems,
Fign. 6 bis 8 perspektivische Darstellungen unterschiedlicher Ausführungsformen der Monitorhalterung.

Die Zeichnungen dienen lediglich zum Verständnis der Erfindung. Gleiche Elemente sind mit denselben Bezugszeichen gekennzeichnet.

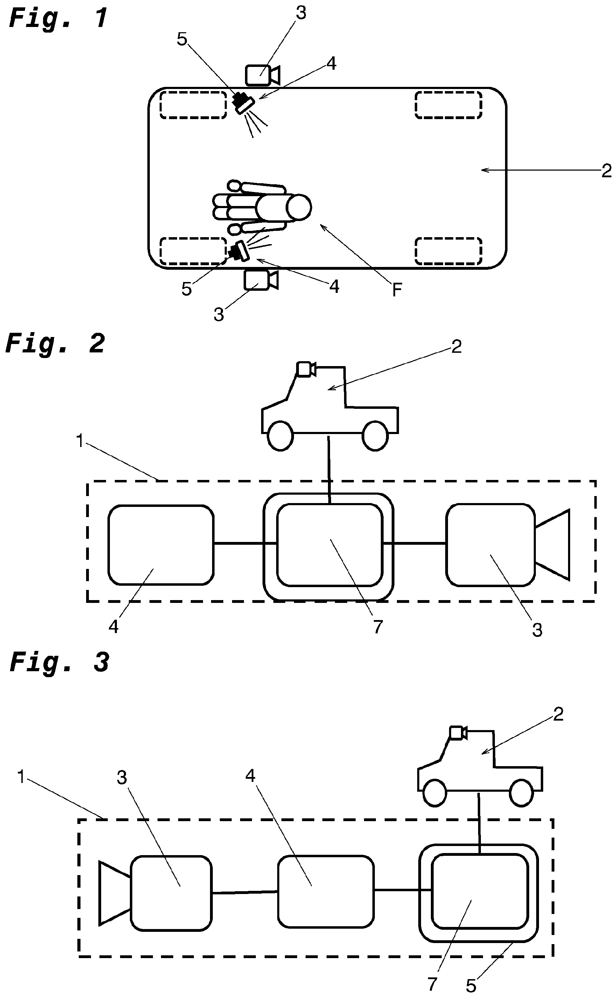

Fign. 1 bis 3 zeigen ein Kamera-Monitor-System 1 für ein Fahrzeug 2, insbesondere ein Nutzfahrzeug, bzw. ein Fahrzeug 2, insbesondere ein Nutzfahrzeug, mit dem Kamera-Monitor-System 1.

Das Kamera-Monitor-System 1 weist eine Kamera 3 mit einer Sensoreinheit auf. Die Kamera 3 ist insbesondere außen am Fahrzeug 2 angebracht. Das Kamera-Monitor-System 1 weist einen Monitor 4 auf. Der Monitor 4 ist insbesondere innen im Fahrzeug 2 angebracht. Vorzugsweise ist der Monitor 4 für einen Fahrer F einsehbar ausgerichtet. Auf dem Monitor kann ein durch die Kamera 3 erfasster Bildbereich für den Fahrer F des Fahrzeugs 2 angezeigt werden.

Insbesondere weist das Fahrzeug 2 zwei Kamera-Monitor-Systeme 1 bzw. ein Kamera-Monitor-System 1 mit zwei beidseitig angebrachten Kameras 3 und zwei Monitoren 4 auf. Insbesondere kann das Kamera-Monitor-System 1 als ein Spiegelersatzsystem dienen.

Das Kamera-Monitor-System 1 weist eine Monitorhalterung 5 zur Anbringung des Monitors 4 am bzw. im Fahrzeug 2 auf. Die Monitorhalterung 5 bildet eine Fahrzeugschnittstelle 6 zur mechanischen Anbindung an das Fahrzeug 2 aus. Der Monitor 4 ist mechanisch in der Monitorhalterung 5 verbaut bzw. fest damit verbunden.

Zudem weist das Kamera-Monitor-System 1 zumindest eine Platine 7 auf. Die Platine 7 ist eine Verarbeitungs- und/oder Recheneinheit. Die Platine 7 (bzw. eine der mehreren Platinen) kann eine Verarbeitungseinheit der Kamera 3, d.h. eine Kameraplatine, sein und/oder die Platine 7 (bzw. eine der mehreren Platinen) kann eine Verarbeitungseinheit des Monitors 4, d.h. eine Monitorplatine, sein und/oder die Platine 7 (bzw. eine der mehreren Platinen) kann eine weitere Verarbeitungseinheit des Kamera-Monitor-Systems, d.h. eine Kamera-Monitor-System-Platine, sein (vgl. Fig. 2). Alternativ oder zusätzlich kann die Platine 7 (bzw. eine der mehreren Platinen) elektronische Fahrzeugschnittstelle bzw. eine Daten- und/oder Kommunikationsschnittstelle zu dem Fahrzeug 2 abbilden (vgl. Fig. 3).

Gemäß einem zentralen Aspekt ist die Platine 7 mechanisch in der Monitorhalterung 5 verbaut. Das heißt, dass die Platine 7 insbesondere in einem Innenraum der Monitorhalterung 5 angeordnet ist. Insbesondere ist die Platine 7 elektronisch mit der Kamera 3 und/oder mit dem Monitor 4 ist und/oder mit dem Fahrzeug 2 verbunden bzw. verbindbar ist.

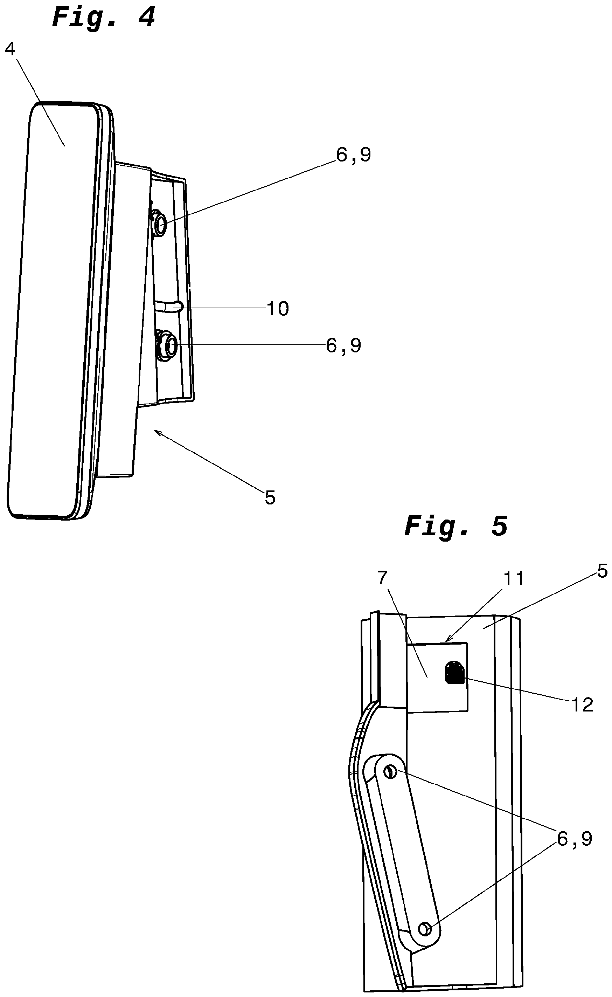

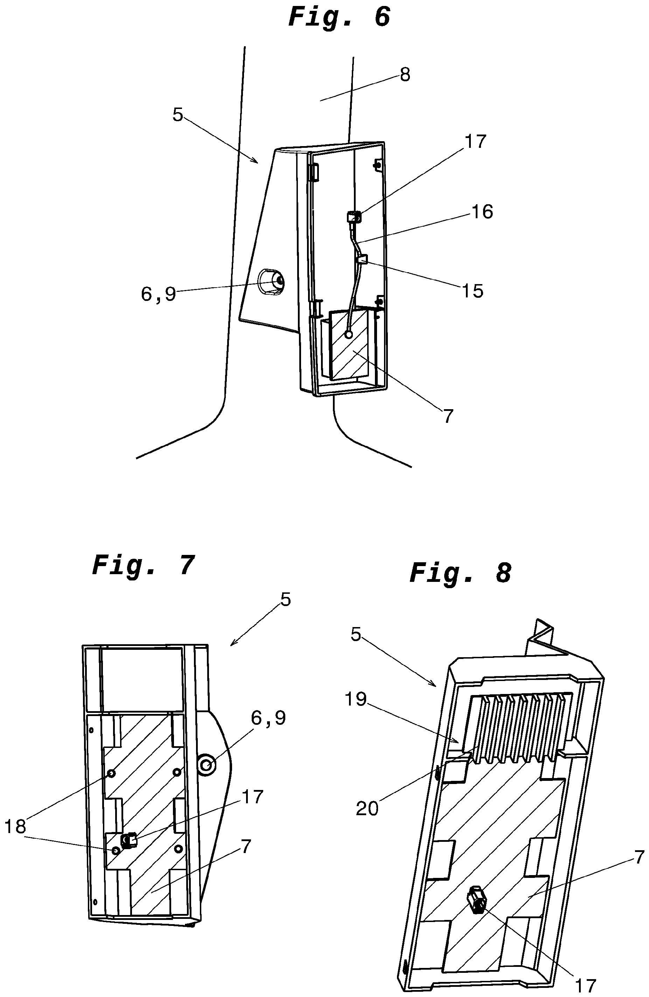

Fign. 4 und 5 zeigen unterschiedliche Ausführungsformen der Monitorhalterung 5 mit dem daran angebrachten Monitor 4. Im am Fahrzeug 2 montierten Zustand ist der Monitor 4 auf einer Vorderseite der Monitorhalterung 5 positioniert. Die Fahrzeugschnittstelle 6 ist so positioniert, dass eine Fahrzeugkabine, insbesondere eine A-Säule 8, des Fahrzeugs 2, die als Gegenschnittstelle dient, auf einer Rückseite der Monitorhalterung 5 ist (vgl. Fig. 6).

In Fig. 4 ist die Fahrzeugschnittstelle 6 durch zwei Schraublöcher 9 zur A-Säule 8 gebildet. Eine Kabelverbindung 10 dient beispielsweise als elektronische bzw. elektrische Verbindung der Platine 7 zu der Kamera 3 und/oder dem Fahrzeug 2 und/oder dem Monitor 4.

In Fig. 5 ist die Fahrzeugschnittstelle 6 durch die zwei Schraublöcher 9 zur A-Säule 8 gebildet. Die Platine 7 ist in einer Gehäuseaussparung 11 der Monitorhalterung 5 angeordnet bzw. durch die Gehäuseaussparung 11 von außen zugänglich. Die Gehäuseaussparung 11 ist auf einer Seite der Monitorhalterung 5 angeordnet, die in Richtung zu der A-Säule 8 hin ausgerichtet ist. An der Platine 7 ist ein Steckverbinder 12 zur A-Säule 8 angeordnet.

Fign. 6 bis 8 zeigen unterschiedliche Ausführungsformen der Monitorhalterung 5.

In Fig. 6 ist die mechanische Fahrzeugschnittstelle 6 durch das Schraubloch 9 zur A-Säule 8 gebildet. Die Platine 7 ist direkt in der Monitorhalterung 5 verbaut. Alternativ kann die Platine 7 auch innerhalb eines (von der Monitorhalterung 5 separaten) Platinengehäuses angeordnet sein, auch wenn dies nicht dargestellt. Das heißt, dass die Platine 7 innerhalb der Monitorhalterung 5 von dem zusätzlichen Platinengehäuse umgeben sein kann. Das Platinengehäuse kann mechanisch, beispielsweise über Schrauben oder eine andere Verbindung, mit der Monitorhalterung 5 verbunden sein. In dem Innenraum der Monitorhalterung 5 ist eine Kabelführung 15 in Form von Halteclips angeordnet. Eine Kabelverbindung 16 dient zur elektronischen bzw. elektrischen Verbindung mit dem Monitor 4. Der Monitor 4 wird über eine elektrische Steckverbindung 17 angebunden.

In Fig. 7 ist die Fahrzeugschnittstelle 6 durch das Schraubloch 9 zur A-Säule 8 gebildet. Die Platine 7 ist direkt an der Monitorhalterung 5 über Schraublöcher 18 angebunden. Die elektrische Steckverbindung 17 zur Anbindung des Monitors 4 ist direkt (d.h. ohne Kabelzuführung) auf der Platine 7 angeordnet.

In Fig. 8 ist die Platine 7 direkt mit der Monitorhalterung 5 verbunden. Die elektrische Steckverbindung 17 zur Anbindung des Monitors 4 ist direkt (d.h. ohne Kabelzuführung) auf der Platine 7 angeordnet. Zudem weist das Kamera-Monitor-System 1 einen Kühlkörper 19 zur Kühlung der Platine 7 und/oder des Monitors 4 auf. Der Kühlkörper 19 weist (im montierten Zustand der Monitorhalterung 5) in Vertikalrichtung ausgerichtete Kühlrippen 20 auf.

### Bezugszeichenliste

- 1: Kamera-Monitor-System
- 2: Fahrzeug
- 3: Kamera
- 4: Monitor
- 5: Monitorhalterung
- 6: Fahrzeugschnittstelle
- 7: Platine
- 8: A-Säule
- 9: Schraubloch
- 10: Kabelverbindung
- 11: Gehäuseaussparung
- 12: Steckverbinder
- 15: Kabelführung
- 16: Kabelverbindung
- 17: Steckverbindung
- 18: Schraubloch
- 19: Kühlkörper
- 20: Kühlrippe

- F: Fahrer

## Patentansprüche

1. Kamera-Monitor-System (1) für ein Fahrzeug (2), vorzugsweise ein Nutzfahrzeug, mit einer Kamera (3), einem Monitor (4), einer Monitorhalterung (5) und einer Platine (7), wobei der Monitor (4) mechanisch in der Monitorhalterung (5) verbaut ist und wobei die Monitorhalterung (5) eine Fahrzeugschnittstelle (6) zur mechanischen Anbindung an das Fahrzeug (2) aufweist, **dadurch gekennzeichnet, dass** die Platine (7) mechanisch in der Monitorhalterung (5) verbaut ist.

2. Kamera-Monitor-System (1) nach Anspruch 1, **dadurch gekennzeichnet, dass** die Platine (7) elektronisch mit der Kamera (3) verbunden ist und/oder elektronisch mit dem Monitor (4) verbunden ist und/oder elektronisch mit dem Fahrzeug (2) verbunden oder verbindbar ist.

3. Kamera-Monitor-System (1) nach Anspruch 1 oder 2, **dadurch gekennzeichnet, dass** die Platine (7) mechanisch direkt mit der Monitorhalterung (5) verbunden ist oder das Kamera-Monitor-System (1) ein die Platine (7) zumindest teilweise umgebendes Platinengehäuse aufweist, das separat von der Monitorhalterung (5) ausgebildet ist und mechanisch mit der Monitorhalterung (5) verbunden ist.

4. Kamera-Monitor-System (1) nach einem der Ansprüche 1 bis 3, **dadurch gekennzeichnet, dass** der Monitor (4) eine Anzeigeeinheit und ein Monitorgehäuse aufweist, wobei das Monitorgehäuse separat von der Monitorhalterung (5) ausgebildet ist und mechanisch mit der Monitorhalterung (5) verbunden ist oder wobei das Monitorgehäuse integral durch die Monitorhalterung (5) gebildet ist.

5. Kamera-Monitor-System (1) nach einem der Ansprüche 1 bis 4, **dadurch gekennzeichnet, dass** die Fahrzeugschnittstelle (6) ausgebildet ist, um an einer A-Säule (8) einer Fahrzeugkabine des Fahrzeugs (2) so montiert zu werden, dass, im an dem Fahrzeug (2) montierten Zustand des Kamera-Monitor-Systems (1), der Monitor (4) an einer Vorderseite der Monitorhalterung (5) positioniert ist und die A-Säule (8) an einer Rückseite oder an einer Seite der Monitorhalterung (5) positioniert ist.

6. Kamera-Monitor-System (1) nach einem der Ansprüche 1 bis 5, **dadurch gekennzeichnet, dass** die Monitorhalterung (5) einen Wasserablauf aufweist, wobei der Wasserablauf vorzugsweise so ausgebildet ist, dass Wasser gezielt von der Platine (7) weggeführt wird.

7. Kamera-Monitor-System (1) nach einem der Ansprüche 1 bis 6, **dadurch gekennzeichnet, dass** das Kamera-Monitor-System (1) ein Schirmblech zur Abschirmung der Platine (7) von EMV-Störstrahlung und/oder einen, insbesondere in dem Innenraum der Monitorhalterung (5) angeordneten, Kühlkörper (19) zur Kühlung des Monitors (4) und/oder der Platine (7) aufweist.

8. Kamera-Monitor-System (1) nach einem der Ansprüche 1 bis 7, **dadurch gekennzeichnet, dass** das Kamera-Monitor-System (1) ein Spiegelersatzsystem, insbesondere ein gesetzlich zugelassenes Spiegelersatzsystem, beispielsweise nach UN/ECE-R46 zugelassenes Spiegelersatzsystem ist.

9. Kamera-Monitor-System (1) nach einem der Ansprüche 1 bis 8, **dadurch gekennzeichnet, dass** die Platine (7) eine Verarbeitungseinheit der Kamera (3) und/oder eine Verarbeitungseinheit des Monitors (4) und/oder eine weitere Verarbeitungseinheit des Kamera-Monitor-Systems (1) ist.

10. Fahrzeug (1), insbesondere Nutzfahrzeug, mit einer Fahrzeugkabine, insbesondere einer A-Säule (8), einer Daten- und/oder Kommunikationseinheit, und einem Kamera-Monitor-System (1) nach einem der Ansprüche 1 bis 9, wobei die Fahrzeugschnittstelle (6) der Monitorhalterung (5) mit der Fahrzeugkabine, insbesondere der A-Säule (8), mechanisch verbunden oder verbindbar ist und/oder die Platine (7) mit der Daten- und/oder Kommunikationseinheit des Fahrzeugs (2) elektronisch verbunden oder verbindbar ist.
